# NEUE EUROPÄISCHE PATENTSCHRIFT

(11) **EP 2 091 312 B2**
(45) Veröffentlichungstag und Bekanntmachung des Hinweises auf die Entscheidung über den Einspruch: **10.06.2020**
(45) Hinweis auf die Patenterteilung: 22.03.2017
(21) Anmeldenummer: 09150924.0
(22) Anmeldetag: 20.01.2009
(51) Int. Cl.: H05K 5/00, H05K 7/14, H01R 9/26, H01R 13/514, H01R 13/629

(54) **Anreihbares Elektronikgehäuse mit Stift- oder Buchsenleisten**
Stackable electronics housing with multi-pin connector or female connector
Boîtier électronique pouvant être joint doté de baguettes à crayon ou manchon

(30) Priorität: 14.02.2008 DE 202008002111 U
(43) Veröffentlichungstag der Anmeldung: 19.08.2009
(73) Patentinhaber: Weidmüller Interface GmbH & Co. KG, 32758 Detmold (DE)
(72) Erfinder: Heggemann, Christian, 32758 Detmold (DE); Oesterhaus, Jens, 32760 Detmold (DE); Bönsch, Matthias, 33659 Bielefeld (DE); Niggemann, Matthias, 32657 Lemgo (DE); Lenschen, Michael, 32756 Detmold (DE); Fehling, Stephan, 32791 Lage (DE); Diekmann, Torsten, 33618 Leopoldshöhe (DE)
(74) Vertreter: Dantz, Jan Henning

(56) Entgegenhaltungen:
- EP-A1- 1 083 637
- EP-A1- 1 592 092
- EP-A1- 1 734 551
- DE-A1- 10 236 397
- DE-A1- 19 737 479
- DE-A1-102004 002 737
- JP-A- 2004 031 036
- US-A- 6 056 582
- US-A1- 2001 034 165

## Beschreibung

Die Erfindung betrifft eine anreihbare Gehäuseanordnung nach Anspruch 1 mit einem Gehäuse, insbesondere Elektronikgehäuse.

Ein solches Gehäuse ist aus der gattungsgemäßen EP 1 083 637 A bekannt. Die DE 10 2004 002 737 A1 betrifft einen Lösemechanismus für ein verrastetes Stecker- bzw. Buchsenteil eines elektrischen Steckverbinders, insbesondere eines Steckermoduls aus der Basisklemme eines Feldbusses für die parallele Verdrahtung von Aktoren und Sensoren. Dabei ist an mindestens einer längsseitigen Ausnehmung des Steckermoduls mindestens ein schwenkbar gelagerter Hebel quer zur Ziehrichtung des Steckermoduls angeordnet, der an einem Ende als Exzenter ausgebildet ist.

Es ist bekannt, an Elektronikgehäusen eine oder mehrere Stiftleisten und/oder Buchsenleisten anzuordnen, die mit einer korrespondierenden Buchsenleiste bzw. Stiftleiste zusammensteckbar sind.

Insbesondere bei einer Auslegung der Elektronikgehäuse als auf eine Tragschiene rastbarer Baustein sind die Einbauverhältnisse in der Regel recht beengt.

In diesem Fall ist es wie beim Stand der Technik oftmals relativ mühsam, einmal miteinander verbundene Stift- und Buchsenleisten wieder voneinander zu lösen.

Die Erfindung hat die Aufgabe, dieses Problem mit einfachen konstruktiven Mitteln zu beheben.

Die Erfindung erreicht dieses Ziel durch den Gegenstand des Anspruchs 1.

Die Entriegelungsvorrichtung unterstützt in einfacher Weise das Lösen der Steckverbindung zwischen der Steck- und der Buchsenleiste. Unter einem Entriegeln ist damit zumindest ein Unterstützen des Trennens der beiden Elemente Stiftleiste und Buchsenleiste voneinander zu verstehen. Sie vergrößert fern in vorteilhafter Weise nicht die Baubreite des eigentlichen Gehäuses, insbesondere des Elektronikgehäuses in Anreihrichtung, so dass sie sich hervorragend zum Einsatz an reihenklemmenartigen Gehäusen eignet.

Es können an dem Elektronikgehäuse nur eine oder auch mehrere Stiftleisten und/oder Buchsenleisten angeordnet sein. Dabei wird vorzugsweise jeder derartigen Anschlussleiste eine der Entriegelungsvorrichtungen zugeordnet.

Mit der vorteilhaften Ausgestaltung des Anspruchs 3 ist es darüber hinaus möglich im montierten Zustand, z.B. in rauer Umgebung an einer Maschine o.dgl., auch nach längerem Einsatz einen sicheren Zusammenhalt der Stift- und Buchsenleiste bzw. elektrischen Kontakte sicherzustellen.

Vorteilhafte Ausgestaltungen der Erfindung sind den Unteransprüchen zu entnehmen.

Nachfolgend wird die Erfindung unter Bezug auf die Zeichnungen anhand von Ausführungsbeispielen näher beschrieben. Es zeigt:
- Figur 1: einen Teilbereich eines Elektronikgehäuses mit einer Stiftleiste, auf das eine Buchsenleiste mit einer Entriegelungsvorrichtung aufgesteckt ist;
- Figur 2 bis 4: in aufeinanderfolgenden Schritten das Lösen bzw. Entriegeln der Buchsenleiste von dem Elektronikgehäuse mit der Stiftleiste nach Figur 1;
- Figur 5: eine Teilbereich eines weiteren Elektronikgehäuses mit einer Stiftleiste, auf das eine Buchsenleiste mit einer kombinierten Ent- und Verriegelungsvorrichtung aufgesteckt ist; und

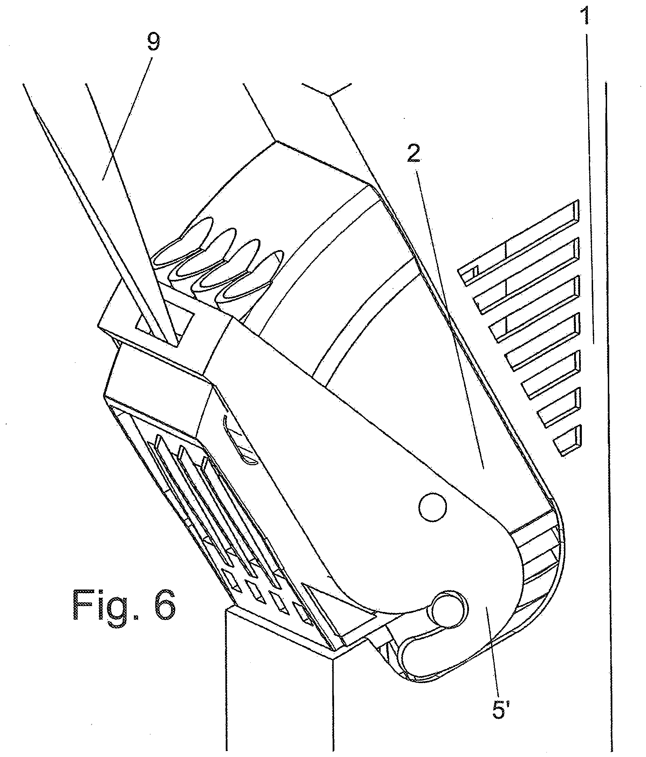

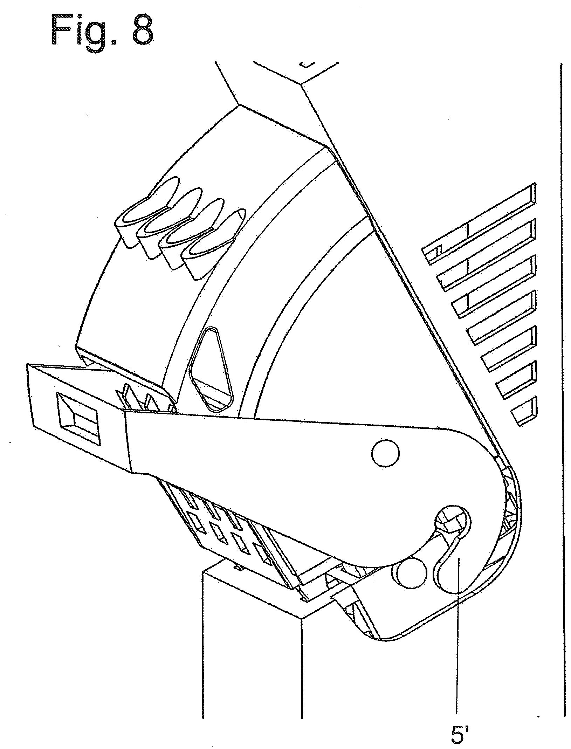

- Figur 6 bis 8: in aufeinanderfolgenden Schritten das Lösen bzw. Entriegeln der Buchsenleiste von dem Elektronikgehäuse mit der Stiftleiste nach Figur 5.

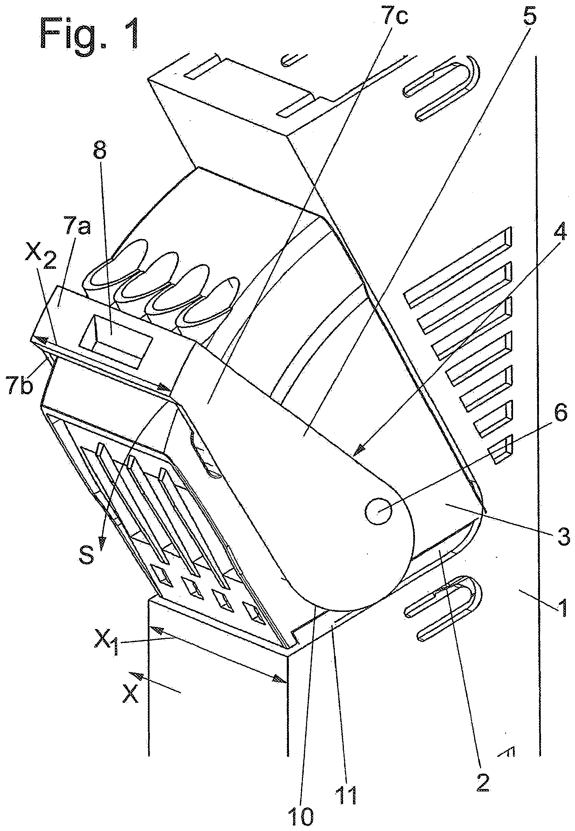

Figur 1 zeigt einen Teilbereich eines Elektronikgehäuses 1, welches vorzugsweise in nicht dargestellter Art einen reihenklemmenartigen Aufbau aufweist und zum Aufrasten auf eine hier nicht dargestellte Tragschiene ausgelegt ist.

Die Anreihrichtung auf der Tragschiene ist in Figur 1 durch die Richtung des Pfeils X angedeutet. In dieser Richtung hat das Gehäuse eine Baubreite X1. In der Regel ist der Einbauraum in Richtung X relativ kurz, so kann das Elektronikgehäuse 1 beispielsweise eine Breite X1 von nur wenigen Millimetern aufweisen.

An dem Elektronikgehäuse 1 ist wenigstens eine Stiftleiste 2 angeordnet oder ausgebildet, die mit dem Elektronikgehäuse 1 fest verbunden oder sogar hinsichtlich ihres eigenen Gehäuses, welche die Kontaktstifte (hier nicht zu erkennen) umgibt, einstückig mit diesem ausgebildet sein kann.

Auf die Stiftleiste 2 ist eine Buchsenleiste 3 angesteckt, die im Wesentlichen vertikal bzw. leicht schräg zur Vertikalen (relativ zur Tragschiene) von oben auf die Stiftleiste 2 aufsetzbar und vorzugsweise an dieser verrastbar und in entgegengesetzter Richtung von dieser lösbar ist.

Zum Lösen der Buchsenleiste 3 von der Stiftleiste 2 ist an der Buchsenleiste 3 eine Entriegelungsvorrichtung 4 angeordnet, die hier als schwenkbarer Entriegelungsbügel 5 ausgebildet ist, der an gegenüberliegenden Seiten der Buchsenleiste 2 mit der Buchsenleiste 2 an Drehachsen 6 gelenkig verbunden ist.

Der Entriegelungsbügel 5 weist im Wesentlichen eine U-Form mit einem Grundschenkel 7a und zwei Seitenschenkeln 7b, 7c auf. Der Entriegelungsbügel 5 umgreift die Buchsenleiste 3 von oben her, wobei der Grundschenkel 7a im wesentlichen oberhalb (relativ zur Tragschiene) der Buchsenleiste 3 angeordnet ist und hier in Richtung der Tragschiene in Richtung des Pfeils S verschwenkbar ist. Der Grundschenkel 7a weist vorzugsweise eine Betätigungskontur 8 zum Ansetzen eines Werkzeugs auf, die hier als Schlitz zum Ansetzen eines Schraubendrehers 9 ausgebildet ist. Eine manuelle Betätigung an einem Ansatz des Bügels oder dgl. wäre ebenfalls denkbar (hier nicht dargestellt).

Die beiden zueinander parallel ausgerichteten Längsschenkel 7b, 7c sind wiederum vorzugsweise parallel zu den in Anreihrichtung (bzw. gegen die Anreihrichtung) X liegenden Hauptaußenflächen 8a, 8b des Elektronikgehäuses angeordnet. Dabei weist die Buchsenleiste mit der Entriegelungsvorrichtung und dem Entriegelungsbügel 5 vorteilhaft in Anreihrichtung eine Breite X2 auf, die zumindest nicht größer oder sogar kleiner ist als die Rasterbreite X1 des Elektronikgehäuses in Anreihrichtung. Derart wird durch die Entriegelungsvorrichtung die gesamte Baubreite des Elektronikgehäuses in Anreihrichtung X nicht vergrößert.

Es ist vorteilhaft, wenn der Entriegelungsbügel 5 mit den Hauptaußenwänden des Elektronikgehäuses 1 in Anreihrichtung fluchtet.

Im Bereich der beiden Längsschenkel 7, 8 des Entriegelungsbügels ist dieser mit einer Entriegelungskontur 10 versehen, die relativ zu den Schwenkachsen 6 eine exzentrisch verlaufende Kontur aufweist, wobei sich diese Entriegelungskontur 10 auf einer Auflagefläche 11 des Elektronikgehäuses (oder alternativ der Stiftleiste, hier nicht dargestellt) abstützt. Besonders bevorzugt ist es, wenn sich die Entriegelungskontur 10 an dem Elektronikgehäuse 1 abstützt.

Zum Entriegeln wird nunmehr mit einem Schraubendreher 12 der Entriegelungsbügel 5 nach unten um die Schwenkachsen 6 verschwenkt, so dass die Entriegelungskontur 10, deren Abstand zur Schwenkachse 6 mit zunehmendem Schwenken des Entriegelungsbügels in die Lösestellung (hier nach unten hin) größer wird, die Buchsenleiste 3 von der Stiftleiste 2 anhebt, da sich die Entriegelungskontur 10 auf der Auflagefläche 11 widerlagerartig abstützt.

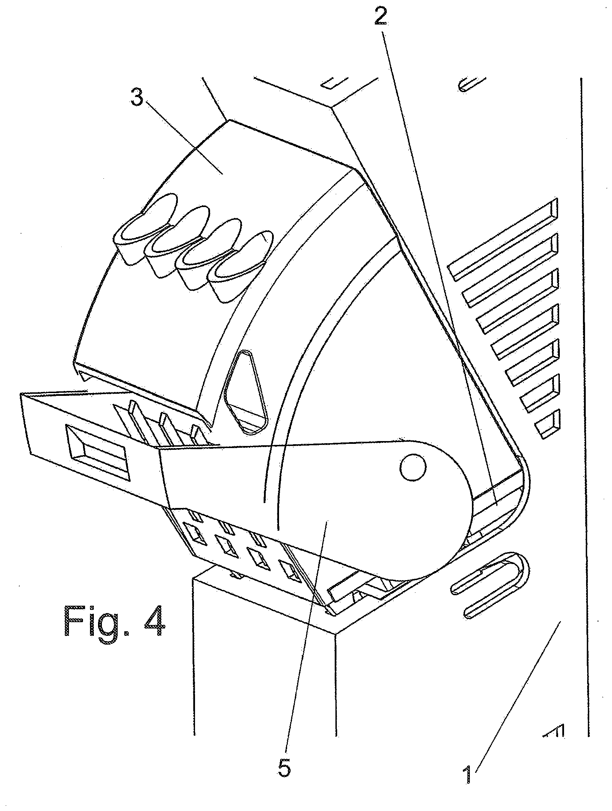

Damit wird das Lösen der Buchsenleiste 3 von der Stiftleiste 2 bzw. das Entriegeln von der Stiftleiste 2 unterstützt, vorzugsweise bis in eine Stellung, in welcher die Buchsenleiste 3 sich in einer nicht kontaktierten Stellung befindet und aus der Position der Figur 4 nach dem Abnehmen des Schraubendrehers vom Elektronikgehäuse 1 bzw. der Stiftleiste 2 abgenommen werden kann.

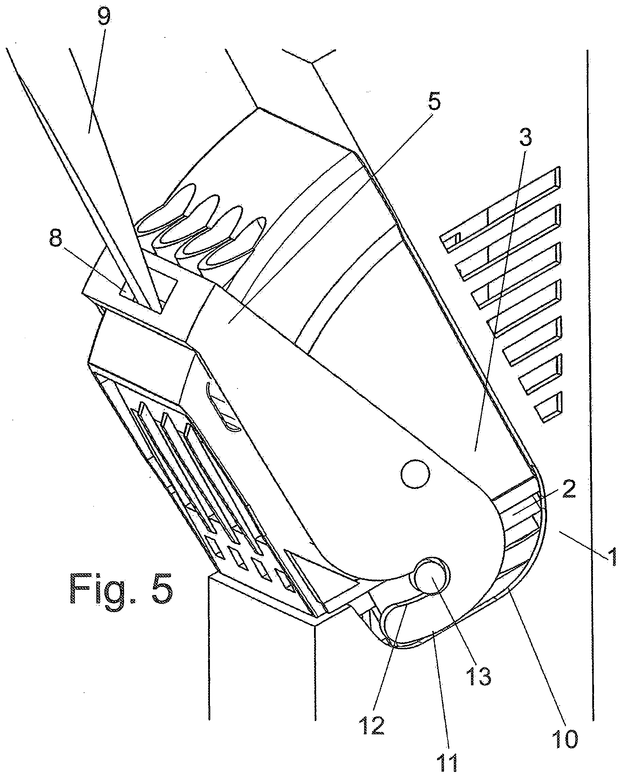

Nach Figur 5 ist es vorgesehen, am Entriegelungsbügel 5 zusätzlich einen Schlitz 12 auszubilden, der eine Bogenform hat und der dazu ausgelegt ist, mit einem Zapfen 13 an der Stiftleiste 1 oder am Elektronikgehäuse 1 zusammenzuwirken. Der Schlitz ist an einem Ende offen und erstreckt sich im Wesentlichen senkrecht zur Steckrichtung, in welcher die Buchsenleiste aufgesteckt und gelöst wird.

Zum Aufsetzen der Buchsenleiste 3 auf die Stiftleiste 1 wird der Entriegelungsbügel 5 in seine in dieser Darstellung untere Position bewegt - die Entriegelungsposition -, so dass die Buchsenleiste 3 auf die Stiftleiste 2 aufsteckbar und dort verrastbar ist.

Sodann wird der Entriegelungsbügel 5 von Hand oder mit einem Schraubendreher in die Stellung der Figur 5 verschwenkt, so dass der Zapfen 13 in den Schlitz 12 eingreift (es ist vorzugsweise auf beiden Seiten der Buchsenleiste in Anreihrichtung betrachtet je einer der Zapfen vorgesehen).

Hierdurch wird eine Verriegelungsfunktion realisiert, da es nicht möglich ist, die Buchsenleiste 3 nach oben hin von der Stiftleiste 2 abzuziehen, da die obere Kante des Schlitzes dies verhindert. Ein Verrasten des Zapfens 13 in einer Aufweitung des Schlitzes oder dgl. ist optional denkbar (hier nicht dargestellt)...

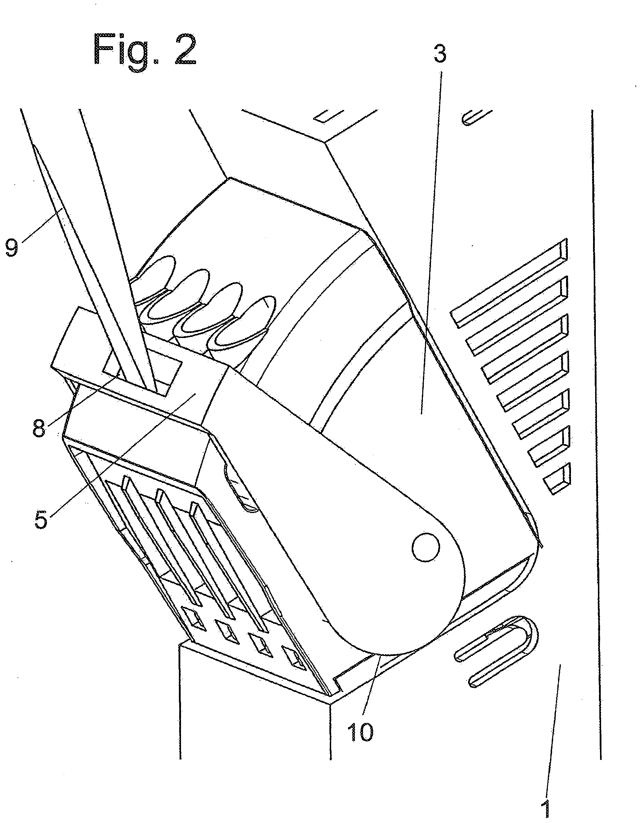

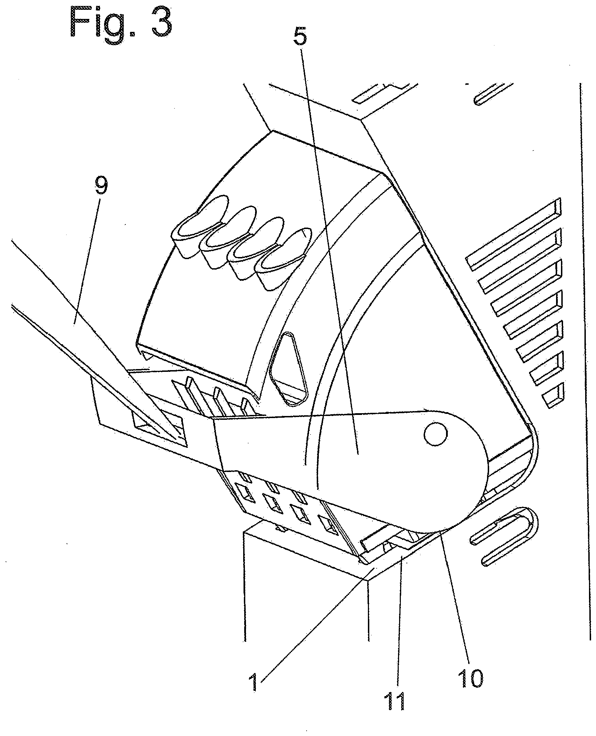

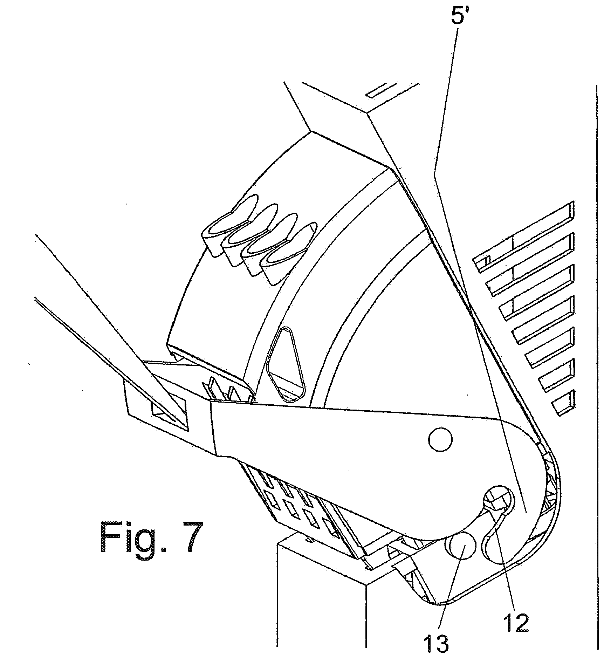

Entriegelt wird diese Anordnung wiederum nach Art der Figur 2 und 3, nämlich dadurch, dass mit Hilfe eines Schraubendrehers 12 der Entriegelungs- und Verriegelungsbügel 5' nach unten verschwenkt wird, was einerseits die Verriegelung löst, da der Zapfen 13 außer Eingriff mit dem Schlitz 12 gelangt (Figur 7) und was zusätzlich eine Lösehilfe bedeutet, wenn der Entriegelungsbügel 5 wiederum nach Art der Fig. 1 derart gestaltet ist, dass er exzentrisch relativ zu der/den Schwenkachsen 6 mit einer Entriegelungskontur 10 ein Anheben der Buchsenleiste 3 von der Steckerleiste 2 beim Bewegen des Bügels bewirkt.

Anzumerken ist, dass bei einer Anordnung der Buchsenleiste am Elektronikgehäuse und einer hierauf aufrastbaren Stiftleiste die Anordnung des Entriegelungsbügels an der Stiftleiste vorgesehen sein kann, wobei die Funktion entsprechend umgekehrt wird.

### Bezugszeichen

- Elektronikgehäuse: 1
- Stiftleiste: 2
- Buchsen leiste: 3
- Entriegelungsvorrichtung: 4
- Entriegelungsbügel: 5, 5'
- Schwenkachsen: 6
- Grundschenkel: 7a
- Längsschenkel: 7b, c
- Betätigungskontur: 8
- Schraubendreher: 9
- Entriegelungskontur: 10
- Auflagefläche: 11
- Schlitz: 12
- Zapfen: 13
- Baubreite: X1, X2
- Anreihrichtung: X
- Pfeil: S

## Patentansprüche

1. Anreihbare Gehäuseanordnung, insbesondere Elektronikgehäuseanordnung, mit einem Gehäuse, insbesondere einem Elektronikgehäuse (1), wobei das Gehäuse mit wenigstens einer oder mehreren Stiftleisten und/oder Buchsenleisten versehen ist, wobei das Gehäuse in Anreihrichtung eine Baubreite (X1) aufweist, und mit jeweils auf die wenigstens eine Stiftleiste (2) oder Buchsenleiste (3) aufsteckbarer korrespondierender Buchsenleiste (3) oder Stiftleiste (2) der Gehäuseanordnung, wobei eine an der aufsteckbaren korrespondierenden Buchsenleiste oder Stiftleiste (3, 2) angeordnete Entriegelungsvorrichtung (4) zum Entriegeln der Buchsenleiste (3) von der Stiftleiste (2) vorgesehen ist, wobei die gesamte Baubreite (X2) der korrespondierenden Stiftleiste (2) oder der korrespondierenden Buchsenleiste (3) mit der Entriegelungsvorrichtung (4) nicht größer ist als die Baubreite (X1) des Gehäuses, insbesondere des Elektronikgehäuses (1), in Anreihrichtung ist, wobei die Entriegelungsvorrichtung (4) als schwenkbarer Entriegelungsbügel (5) ausgebildet ist, der an gegenüberliegenden Seiten der korrespondierenden Buchsenleiste (2) oder der korrespondierenden Stiftleiste (3) an Schwenkachsen (6) mit dieser gelenkig verbunden ist, wobei der Entriegelungsbügel (5) mit einer relativ zu den Schwenkachsen (6) exzentrisch verlaufenden Entriegelungskontur (10) versehen ist, die sich beim Entriegeln auf einer Auflagefläche (11) des Gehäuses oder der Stiftleiste widerlagerartig abstützt, und wobei der Entriegelungsbügel (5) mit dem Elektronikgehäuse (1) in Anreihrichtung fluchtet und wobei der Entriegelungsbügel (5) eine U-Form mit einem Grundschenkel (7a) und zwei Seitenschenkeln (7b, 7c) aufweist.

2. Elektronikgehäuse nach Anspruch 1, wobei der Entriegelungsbügel (5) die Buchsenleiste (3) umgreift und dass der Grundschenkel (7a) eine Betätigungskontur (8) aufweist.

3. Elektronikgehäuse nach einem der vorstehenden Ansprüche, wobei die Entriegelungsvorrichtung (4) mit einer Verriegelungseinrichtung nach Art einer baulichen Einheit kombiniert ist.

4. Elektronikgehäuse nach einem der vorstehenden Ansprüche, wobei der Entriegelungsbügel (5) wenigstens einen Schlitz (12) aufweist, der dazu ausgelegt ist, verriegelnd mit einem Zapfen (13) an der Stiftleiste (1) oder am Elektronikgehäuse zusammenzuwirken.

## Claims

1. A stackable housing arrangement, especially an electronic housing arrangement, comprising a housing, especially an electronic housing (1), wherein the housing is provided with at least one or several contact-pin strips and/or socket-pin strips, wherein the housing has a mounting width (X1) in the stacking direction, and comprising corresponding socket-pin strip (3) or contact-pin strip (2) of the housing arrangement which can respectively be inserted onto the at least one contact-pin strip (2) or socket-pin strip (3), wherein an unlocking apparatus (4) for unlocking the socket-pin strip (3) from the contact-pin strip (2) is provided, which unlocking apparatus is arranged on the insertable corresponding socket-pin strip or contact-pin strip (3, 2), wherein the entire overall mounting width (X2) of the corresponding contact-pin strip (2) or the corresponding socket-pin strip (3) with the unlocking apparatus (4) is not greater than the mounting width (X1) of the housing, especially the electronic housing (1), in the stacking direction, wherein the unlocking apparatus (4) is formed as a pivotable unlocking yoke (5) which is connected in an articulated manner to pivot pins (6) on opposite sides of the corresponding contact-pin strip (2) or the corresponding socket-pin strip (3), wherein the unlocking yoke (5) is provided with an unlocking contour (10) which extends eccentrically relative to the pivot pins (6) and which during unlocking rests in the manner of an abutment on the bearing surface (11) of the housing or the contact-pin strip, and wherein the unlocking yoke (5) is in alignment in the stacking direction with the electronic housing (1), and wherein the unlocking yoke (5) has a U-shape with a base leg (7a) and two side legs (7b, 7c).

2. An electronic housing according to claim 1, wherein the unlocking yoke (5) engages around the socket-pin strip (3), and the base leg (7a) has an actuating contour (8).

3. An electronic housing according to one of the preceding claims, wherein the unlocking apparatus (4) is combined with a locking device in the manner of a structural unit.

4. An electronic housing according to one of the preceding claims, wherein the unlocking yoke (5) comprises at least one slot (12) which is formed to interact in a locking manner with a pin (13) on the contact-pin strip (1) or on the electronic housing.

## Revendications

1. Disposition de boîtier pouvant être alignée, en particulier disposition de boîtier électronique, avec un boîtier, en particulier un boîtier électronique (1), dans laquelle le boîtier est doté d'au moins une ou plusieurs réglettes de broches et/ou réglettes de douilles, dans laquelle le boîtier présente dans le sens d'alignement une largeur de construction (X1), et avec une réglette de douilles (3) ou réglette de broches (2) correspondante de la disposition de boîtier emboîtable respectivement sur l'au moins une réglette de broches (2) ou réglette de douilles (3), dans laquelle un dispositif de déverrouillage (4) disposé sur une réglette de douilles ou réglette de broches (2, 3) emboîtable correspondante pour déverrouiller la réglette de douilles (3) de la réglette de broches (2) est prévu, la largeur de construction totale (X2) de la réglette de broches (2) correspondante ou de la réglette de douilles (3) correspondante avec le dispositif de déverrouillage (4) n'étant pas plus grande que la largeur de construction (X1) du boîtier, en particulier du boîtier électronique (1), dans le sens d'alignement, le dispositif de déverrouillage (4) étant construit comme un étrier de déverrouillage (5) pivotant qui est articulé à la réglette de douilles (2) ou à la réglette de broches (3) sur des axes de pivotement (6) sur des côtés opposés de celle-ci, dans laquelle l'étrier de déverrouillage (5) est doté d'un contour de déverrouillage (10) excentré par rapport aux axes de pivotement (6), qui s'appuie comme un contre-appui sur une surface d'appui (11) du boîtier ou de la réglette de broches lors du déverrouillage, dans laquelle l'étrier de déverrouillage (5) est aligné avec le boîtier électronique (1) dans le sens d'alignement et dans laquelle l'étrier de déverrouillage (5) est en forme de U avec un bras de base (7a) et deux bras latéraux (7b, 7c).

2. Boîtier électronique selon la revendication 1, dans lequel l'étrier de déverrouillage (5) entoure la réglette de douilles (3) et le bras de base (7a) présente un contour d'actionnement (8).

3. Boîtier électronique selon l'une des revendications précédentes, dans lequel le dispositif de déverrouillage (4) est combiné à un dispositif de verrouillage en formant une unité de construction.

4. Boîtier électronique selon l'une des revendications précédentes, dans lequel l'étrier de déverrouillage (5) présente au moins une fente (12) conçue pour coopérer en vue du verrouillage avec un tenon (13) sur la réglette de broches (1) ou sur le boîtier électronique.
